# EUROPÄISCHE PATENTANMELDUNG

(11) **EP 0 895 289 A2**
(43) Veröffentlichungstag der Anmeldung: **03.02.1999**
(21) Anmeldenummer: 98113094.1
(22) Anmeldetag: 14.07.1998
(51) Int. Cl.: H01L 23/66

(54) **Digitaler Schaltkreis in MOS-Technologie**

(30) Priorität: 25.07.1997 DE 19732177
(71) Anmelder: SIEMENS AKTIENGESELLSCHAFT, 80333 München (DE)
(72) Erfinder: Buck, Martin, 81243 München (DE)

(57) **Zusammenfassung**

Die Erfindung betrifft einen digitalen Schaltkreis in MOS-Technologie, bei dem auf einem Halbleiterkörper (1) eine dielektrische Schicht (5) vorgesehen ist. Zur Energieübertragung mittels eines Signales ist auf dem Halbleiterkörper (1) eine Mikrowellen-Streifenleitung (2) aus einer Metall-Streifenleitung (3) und einer Dotierungswanne (4) angeordnet.

## Beschreibung

Die vorliegende Erfindung betrifft einen digitalen Schaltkreis in MOS-Technologie, bei dem auf einem Halbleiterkörper eine dielektrische Schicht vorgesehen ist.

Digitale Schaltungen werden bekanntlich zur Erzielung großer Geschwindigkeiten mit möglichst hohen Frequenzen betrieben. Solche hohen Frequenzen verursachen aber zwangsläufig Kopplungen und Rauschprozesse zwischen einzelnen Leitungen und Bauelementen im Halbleiterkörper. Die durch diese Kopplungen und Rauschprozesse verursachten Spannungsschwankungen im Halbleiterkörper können die Funktion des darin realisierten digitalen Schaltkreises erheblich beeinträchtigen.

Als Abhilfe gegen diese Störungen wird versucht, die digitalen Schaltkreise so aufzubauen, daß sie möglichst unempfindlich gegen Rauschprozesse sind. Dies kann durch entsprechede Führung der Leitungen und Anordnung der einzelnen Bauelemente geschehen, indem beispielsweise bestimmte Abstandskriterien eingehalten werden. Letztlich führt dies aber ebenso wie eine Verminderung der Schaltgeschwindigkeit zu einer Verringerung der Betriebsfrequenzen des digitalen Schaltkreises, die gerade vermieden werden soll.

Es ist daher Aufgabe der vorliegenden Erfindung, einen digitalen Schaltkreis in MOS-Technologie zu schaffen, der mit hohen Betriebsfrequenzen arbeitet und dennoch praktisch keine Kopplungen und Rauschprozesse zeigt.

Diese Aufgabe wird bei einem digitalen Schaltkreis der eingangs genannten Art erfindungsgemäß dadurch gelöst, daß zur Signalübertragung auf den Halbleiterkörper eine Mikrowellen-Streifenleitung aufgetragen ist.

Die Erfindung beschreitet damit einen vollkommen neuartigen Weg: anstelle der üblichen Metalleitungen wird nämlich eine Mikrowellen-Streifenleitung zur Signalübertragung herangezogen. Damit wird die Energie eines Signales nicht mehr auf einer Metalleitung übertragen, sondern vielmehr im elektrischen Feld zwischen den Streifen der Mikrowellen-Streifenleitung transportiert. Dies bedeutet aber, daß sich das elektrische Feld praktisch vollständig zwischen den Streifen der Mikrowellen-Streifenleitung befindet, so daß nur äußerst geringe Kopplungen zu benachbarten Leitungen und Bauelementen bestehen und nur geringe Rauschprozesse auftreten. Es ist damit möglich, Signale mit hohen Frequenzen zu übertragen, so daß der erfindungsgemäße digitale Schaltkreis sich durch eine hohe Schaltgeschwindigkeit bei nur geringen Kopplungen und Rauschprozessen auszeichnet.

In vorteilhafter Weise wird die Mikrowellen-Streifenleitung durch eine Metall-Streifenleitung auf der dielektrischen Schicht und eine weitere Streifenleitung in der Form einer Dotierungswanne im Halbleiterkörper im Bereich unterhalb der Metall-Streifenleitung realisiert. Anstelle der Dotierungswanne kann ggf. auch ein zweiter Metallstreifen verwendet werden. Die Mikrowelle breitet sich dann im Bereich zwischen der Metall-Streifenleitung und der Dotierungswanne bzw. dem zweiten Metallstreifen aus.

Die Dotierungswanne kann als Massekontakt für die Mikrowellen-Streifenleitung dienen. Sie wird in bevorzugter Weise durch Diffusion in den Halbleiterkörper eingebracht und ist höher dotiert als dieser. Ein geeignetes Material für die Metall-Streifenleitung ist beispielsweise Aluminium.

Die Dicke und Breite der Streifenleitung, die Schichtdicke der dielektrischen Schicht und die Dotierungskonzentration der Dotierungswanne können bedarfsabhängig eingestellt werden. Die einzustellenden Werte hängen von zahlreichen Faktoren ab, wie z.B. Betriebsfrequenz, Dielektrizitätskonstante der dielektrischen Schicht, usw.

Wesentlich an der vorliegenden Erfindung ist der erstmals als realisierbar erkannte Einsatz hochfrequenztechnischer Elemente, nämlich insbesondere der Mikrowellen-Streifenleitung bei einem digitalen Schaltkreis in MOS-Technologie.

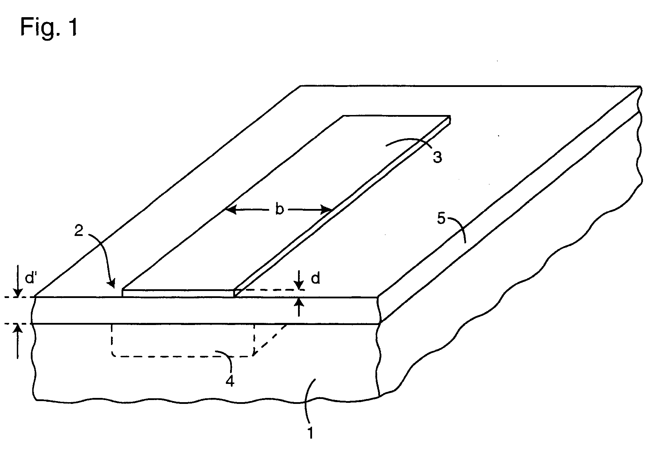

Nachfolgend wird die Erfindung anhand der Zeichnung näher erläutert, in deren einziger Figur ein Ausführungsbeispiel des erfindungsgemäßen digitalen Schaltkreises schematisch gezeigt ist.

Auf einem Halbleiterkörper 1, der beispielsweise aus Silizium besteht, ist eine Mikrowellen-Streifenleitung 2 aus einer Metall-Streifenleitung 3 und einer Dotierungswanne 4 vorgesehen. Die Dotierungswanne 4 ist im Bereich unterhalb der Metall-Streifenleitung 3 im Halbleiterkörper 1 angeordnet und kann durch Diffusion hergestellt sein. Ein geeignetes Material für die Metall-Streifenleitung 3 ist beispielsweise Aluminium. Die Dicke d der Metall-Streifenleitung 3 und ihre Breite b werden bedarfsmäßig eingestellt.

Zwischen der Metall-Streifenleitung 3 und der Dotierungswanne 4 befindet sich eine dielektrische Schicht 5 aus beispielsweise Siliziumdioxid. Die Schichtdicke d' dieser dielektrischen Schicht 5 wird ebenfalls bedarfsabhängig eingestellt.

Auf diese Weise bilden die Metall-Streifenleitung 3 und die Dotierungswanne 4 beispielsweise eine M⁰-Leitung. Diese Leitung überträgt die Energie eines Signales im elektrischen Feld zwischen der Metall-Streifenleitung 3 und der Dotierungswanne 4, also in dem Bereich der dielektrischen Schicht 5, der zwischen der Metall-Streifenleitung 3 und der Dotierungswanne 4 gelegen ist. Da das elektrische Feld sich damit im wesentlichen zwischen den beiden "Streifen" aus der Metall-Streifenleitung 3 und der Dotierungswanne 4 befindet, wird die Kopplung zu benachbarten Leitungen und Bauelementen äußerst gering, so daß besonders hohe Frequenzen übertragen werden können.

Die Einkopplung von Signalen und deren Auskopplung in die bzw. aus der Mikrowellen-Streifenleitung 2 kann beispielsweise mittels Hochfrequenztransistoren erfolgen.

Weiterhin kann im dargestellten Ausführungsbeispiel die Dotierungswanne 4 als Massekontakt der Mikrowellen-Streifenleitung 2 herangezogen werden.

## Patentansprüche

1. Digitaler Schaltkreis in MOS-Technologie, bei dem auf einem Halbleiterkörper (1) eine dielektrische Schicht (5) vorgesehen und zur Energieübertragung mittels eines Signales auf den Halbleiterkörper (1) eine Mikrowellen-Streifenleitung (2) aufgetragen ist,
**dadurch gekennzeichnet,**
daß ein Streifen der Mikrowellen-Streifenleitung (2) aus einer Metall-Streifenleitung (3) auf der dielektrischen Schicht (5) besteht und der andere Streifen im Halbleiterkörper (1) im Bereich unterhalb der Metall-Streifenleitung (3) als eine Dotierungswanne (4) ausgebildet ist.

2. Digitaler Schaltkreis nach Anspruch 1,
**dadurch gekennzeichnet,**
daß die Dotierungswanne (4) als Massekontakt der Mikrowellen-Streifenleitung (2) dient.

3. Digitaler Schaltkreis nach Anspruch 1 oder 2,
**dadurch gekennzeichnet,**
daß die Dotierungswanne (4) durch Diffusion in den Halbleiterkörper (1) eingebracht und höher dotiert als dieser ist.

4. Digitaler Schaltkreis nach einem der Ansprüche 1 bis 3,
**dadurch gekennzeichnet,**
daß die Metall-Streifenleitung aus Aluminium besteht.
